# EUROPEAN PATENT APPLICATION

(11) **EP 1 248 301 A2**
(43) Date of publication of application: **09.10.2002**
(21) Application number: 02005647.9
(22) Date of filing: 12.03.2002
(51) Int. Cl.: H01L 29/788

(54) **Non-volatile semiconductor storage device and method for producing the same**

(30) Priority: 05.04.2001 JP 2001107453
(71) Applicant: MATSUSHITA ELECTRIC INDUSTRIAL CO., LTD., Kadoma-shi, Osaka 571-8501 (JP); Halo Lsi Design and Device Technology Inc., Wappingers Falls, NY 12590 (US)
(72) Inventor: Kamada, Akihiro, Ibaraki-shi, Osaka 567-0034 (JP); Fujimoto, Hiromasa, Soraku-gun, Kyoto 619-0224 (JP); Okada, Kenji, Toyonaka-shi, Osaka 565-0085 (JP); Ogura, Seiki, c/o HALO LSI Design&Device Techn.Inc, Wappingers Falls, NY 12590 (US)
(74) Representative: Grünecker, Kinkeldey, Stockmair & Schwanhäusser Anwaltssozietät

(57) **Abstract**

A non-volatile semiconductor storage device includes a semiconductor substrate provided with a step portion (11a) in an upper portion thereof, and having a first region (11b) that is an upper level of the step portion and a second region (11c) that is a lower level thereof, a control gate electrode (13) formed on the first region of the semiconductor substrate via a gate insulating film (12), and a floating gate electrode (15) formed on the side face of the control gate electrode on the side of the step portion and on the step portion via an insulating film (14). The side face of the step portion forms an obtuse angle with respect to the upper surface of the second region, and the insulating film (14) has a substantially uniform thickness on the step portion (11a).

## Description

### BACKGROUND OF THE INVENTION

The present invention relates to a non-volatile semiconductor storage device, in particular, a non-volatile semiconductor storage device in which a floating gate electrode is formed on a step portion of a semiconductor substrate, and a method for producing the same.

At present, flash EEPROMs (electrically erasable programmable read only memories) are widely used as non-volatile storage devices on which electrical write and erase can be performed. The cell structure of a memory cell of such a non-volatile semiconductor storage device can be classified roughly into two types. One is a stack gate type having a structure in which a control gate electrode is stacked on a floating gate electrode, and the other is a split gate type having a structure in which both the floating gate electrode and the control gate electrode are opposed to a channel region.

Hereinafter, the split gate type non-volatile semiconductor storage device provided with a step portion below a floating gate electrode in order to improve the write property that is proposed in US Patent No. 6051860 will be described.

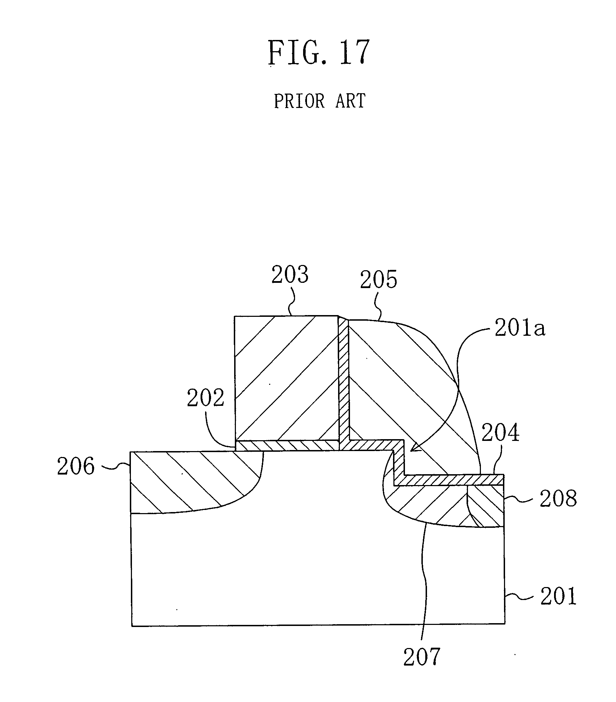

Figure **17** shows a cross-sectional structure of the non-volatile semiconductor storage device disclosed in the above publication. As shown in Figure **17,** a control gate electrode **203** is formed on a region of the upper level of a semiconductor substrate **201** having a step portion **201a** in its upper portion via a gate insulating film **202.** On the step portion **201a** of the semiconductor substrate **201,** a floating gate electrode **205** is formed, opposing the side face of the control gate electrode **203** via an insulating film **204.** The insulating film **204** serves as a capacitance insulating film in a portion that is opposed to the control gate electrode **203** and serves as a tunnel insulating film in a portion that is opposed to the semiconductor substrate **201.**

A source diffusion layer **206** is formed in a region to the side of the gate electrode **203** on the upper level of the semiconductor substrate **201.** A low concentration drain diffusion layer **207** is formed in a region below the floating gate electrode **205** on the lower level of the semiconductor substrate **201,** and a high concentration drain diffusion layer **208** is formed outside the low concentration drain diffusion layer **207.**

However, the conventional non-volatile semiconductor storage device has the insulating film **204** that serves as a tunnel insulating film on the step portion **201a.** Therefore, the insulating film **204** is less reliable than a tunnel insulating film formed on a flat substrate in which the step portion **201a** is not formed. This is caused for the following reason. When forming a tunnel insulating film on a semiconductor substrate having the step portion **201a** by thermal oxidation, a stress due to thermal oxidation is applied to the corners on the upper level and the lower level of the step portion **201a** in the tunnel insulating film, so that a film having a uniform thickness cannot be formed. As a result, a stress due to an electric field concentrates in the corners so that the quality of the film is poor.

### SUMMARY OF THE INVENTION

It is an object of the present invention to solve the above-described conventional problem in the non-volatile semiconductor storage devices including a semiconductor substrate having a step portion below a floating gate electrode and to improve the reliability of a tunnel insulating film covering the step portion.

In order to achieve the above object, in the present invention, the angle formed between the side face of the step portion and the surface on the lower level thereof is an obtuse angle, or the present invention has a multilayered structure in which the tunnel insulating film includes a thermal oxide film and a deposited oxide film.

More specifically, a first non-volatile semiconductor storage device of the present invention includes a semiconductor substrate provided with a step portion in an upper portion thereof, and having a first region that is an upper level of the step portion and a second region that is a lower level thereof; a control gate electrode formed on the first region of the semiconductor substrate via a gate insulating film; and a floating gate electrode formed on the side face of the control gate electrode on the side of the step portion and on the step portion via an insulating film. The side face of the step portion forms an obtuse angle with respect to the upper surface of the second region, and the insulating film has a substantially uniform thickness on the step portion.

According to the first non-volatile semiconductor storage device, even if the insulating film is formed by thermal oxidation, a stress applied to the corners on the upper level and the lower level of the step portion in the insulating film is small, so that the thickness of the insulating film can be uniform. Therefore, the reliability of the insulating film serving as the tunnel insulating film is improved because of the uniform quality of the insulating film.

It is preferable that the angle formed between the side face of the step portion and the upper surface of the second region is about 100° or more.

It is preferable that the angle formed between the side face of the step portion and the upper surface of the second region is about 110° or more and about 130° or less. With this, when forming, for example, an n-type drain diffusion layer in the second region, the amount of ions implanted into the side face of the step portion is reduced, which can prevent n-type impurities from suppressing implantation of electrons into the floating gate electrode during a write operation.

In the first non-volatile semiconductor storage device, it is preferable that the insulating film is a thermal oxide film. This embodiment improves the film quality of the insulating film as a tunnel insulating film.

A second non-volatile semiconductor storage device of the present invention includes a semiconductor substrate provided with a step portion in an upper portion thereof, and having a first region that is an upper level of the step portion and a second region that is a lower level thereof; a control gate electrode formed on the first region of the semiconductor substrate via a gate insulating film; and a floating gate electrode formed on a side face of the control gate electrode on a side of the step portion and on the step portion via a first insulating film and a second insulating film provided in this order from the substrate. The second insulating film is formed with a deposited film.

According to the second non-volatile semiconductor storage device, even if the tilt angle of the step portion in the second insulating film formed with a deposited film is small, that is, an angle close to 90°, the thickness in the corners of the step portion is not thin as opposed to a thermal oxide film. Therefore, since the thickness of the second insulating film is uniform, the film quality of the tunnel insulating film including the first and second insulating films is improved.

In the second non-volatile semiconductor storage device, it is preferable that the first insulating film is a thermal oxide film, and the second insulating film is an oxide film. With this, the tunnel insulating film having a multilayered structure can be formed reliably. Moreover, the first insulating film on the substrate side becomes dense, and the thickness of the second insulating film becomes uniform.

In the second non-volatile semiconductor storage device, it is preferable that the first insulating film is a thermal oxide film, and the second insulating film is an oxynitride film. In this embodiment, the second insulating film serving as a capacitance insulating film in a portion that is opposed to the control gate electrode is an oxynitride film, and therefore the charge retention characteristics of the floating gate electrode can be improved.

A third non-volatile semiconductor storage device of the present invention includes a semiconductor substrate provided with a step portion in an upper portion thereof, and having a first region that is an upper level of the step portion and a second region that is a lower level thereof; a control gate electrode formed on the first region of the semiconductor substrate via a gate insulating film; and a floating gate electrode formed on a side face of the control gate electrode on a side of the step portion and on the step portion via a first insulating film, a second insulating film and a third insulating film provided in this order from the substrate. The third insulating film is formed with a deposited film.

According to the third semiconductor storage device, even if the tilt angle of the step portion in the third insulating film formed with a deposited film is close to 90°, the thickness in the corners of the step portion in the third insulating film is not thin. Therefore, since the thickness of the third insulating film is uniform, the film quality of the tunnel insulating film including the first, second and third insulating films is improved.

In the third non-volatile semiconductor storage device, it is preferable that the first insulating film and the second insulating film are thermal oxide films, and the third insulating film is an oxide film.

In the third non-volatile semiconductor storage device, it is preferable that the first insulating film is a thermal oxide film, the second insulating film is an oxynitride film formed by thermal oxidation, and the third insulating film is an oxynitride film.

A first method for producing a non-volatile semiconductor storage device includes a first step of forming a gate insulating film and a gate electrode sequentially on a semiconductor substrate; a second step of forming a side wall on a side face of the control gate electrode and then etching the semiconductor substrate using the formed side wall as a mask, thereby forming a first region on which the side wall is located, a second region obtained by etching the first region, and a step portion connecting the first region and the second region such that an angle formed between a side face of the step portion and an upper surface of the second region becomes an obtuse angle; a third step of removing the side wall and then forming an insulating film over the side face of the control gate electrode on the side of the step portion, the first region, the step portion and the second region; and a fourth step of forming a floating gate electrode on the side face of the control gate electrode on the side of the step portion and the second region including the step portion on the insulating film in a self-alignment manner.

According to the first method for producing a non-volatile semiconductor storage device, a first region on which the side wall is located, a second region obtained by etching the first region, and a step portion connecting the first region and the second region are formed such that the angle formed between the side face of the step portion and the upper surface of the second region becomes an obtuse angle. Therefore, the first non-volatile semiconductor storage device of the present invention can be obtained reliably.

It is preferable that in the second step of the first method for producing a non-volatile semiconductor storage device, the step portion and the second region are formed by isotropic dry etching.

It is preferable that in the second step of the first method for producing a non-volatile semiconductor storage device, the step portion and the second region are formed by wet etching.

It is preferable that in the second step of the first method for producing a non-volatile semiconductor storage device, the step portion and the second region are formed by dry etching and wet etching.

It is preferable that in the second step of the first method for producing a non-volatile semiconductor storage device, the angle formed between the side face of the step portion and the upper surface of the second region is about 100° or more.

It is preferable that in the second step of the first method for producing a non-volatile semiconductor storage device, the angle formed between the side face of the step portion and the upper surface of the second region is about 110° or more and about 130° or less.

A second method for producing a non-volatile semiconductor storage device of the present invention includes a first step of forming a gate insulating film and a gate electrode sequentially on a semiconductor substrate; a second step of forming a side wall on a side face of the control gate electrode and then etching the semiconductor substrate using the formed side wall as a mask, thereby forming a first region on which the side wall is located, a second region obtained by etching the first region, and a step portion connecting the first region and the second region; a third step of removing the side wall and then forming a first insulating film over the side face of the control gate electrode on the side of the step portion, the first region, the step portion and the second region by deposition; a fourth step of forming a second insulating film at the interface between the first insulating film and the side face of the control gate electrode on the side of the step portion, the first region, the step portion and the second region by thermal oxidation; and a fifth step of forming a floating gate electrode on the side face of the control gate electrode on the side of the step portion and the second region including the step portion on the first insulating film in a self-alignment manner.

According to the second method for producing a non-volatile semiconductor storage device, a second insulating film is formed at the interface between the first insulating film and the side face of the control gate electrode on the side of the step portion, the first region, the step portion and the second region by thermal oxidation. Thus, the second insulating film formed by thermal oxidation and the first insulating film formed by deposition are provided in this order from the step portion side. Therefore, the second non-volatile semiconductor storage device of the present invention can be obtained reliably.

It is preferable that in the third step of the second method for producing a non-volatile semiconductor storage device, the first insulating film is an oxynitride film.

It is preferable that in the fourth step of the second method for producing a non-volatile semiconductor storage device, the second insulating film is formed in an ambient containing nitrogen. With this, the first insulating film formed by deposition in the previous step can be nitridized during formation of the second insulating film.

It is preferable that the second method for producing a non-volatile semiconductor storage device further includes a step of performing an annealing treatment in a non-oxidative ambient with respect to the first insulating film and the second insulating film between the fourth step and the fifth step. With this, the film quality of the first insulating film formed by deposition is improved.

A third method for producing a non-volatile semiconductor storage device of the present invention includes a first step of forming a gate insulating film and a gate electrode sequentially on a semiconductor substrate; a second step of forming a side wall on a side face of the control gate electrode and then etching the semiconductor substrate using the formed side wall as a mask, thereby forming a first region on which the side wall is located, a second region obtained by etching the first region, and a step portion connecting the first region and the second region; a third step of removing the side wall and then forming a first insulating film over the side face of the control gate electrode on the side of the step portion, the first region, the step portion and the second region by thermal oxidation; a fourth step of forming a second insulating film on the first insulating film by deposition; a fifth step of forming a third insulating film at the interface between the first insulating film and the side face of the control gate electrode on the side of the step portion, the first region, the step portion and the second region by thermal oxidation; and a sixth step of forming a floating gate electrode on the side face of the control gate electrode on the side of the step portion and the second region including the step portion on the second insulating film in a self-alignment manner.

According to the third method for producing a non-volatile semiconductor storage device, a third insulating film is formed at the interface between the first insulating film and the side face of the control gate electrode on the side of the step portion, the first region, the step portion and the second region by thermal oxidation. Thus, the third and first insulating film formed by thermal oxidation and the second insulating film formed by deposition on the first insulating film are provided in this order from the step portion side. Therefore, the third non-volatile semiconductor storage device of the present invention can be obtained reliably.

It is preferable in the third method for producing a non-volatile semiconductor storage device that in the fourth step, the second insulating film is an oxynitride film.

It is preferable in the third method for producing a non-volatile semiconductor storage device that in the fifth step, the third insulating film is formed in an ambient containing nitrogen.

It is preferable that the third method for producing a non-volatile semiconductor storage device further includes a step of performing an annealing treatment in a non-oxidative ambient with respect to the first insulating film, the second insulating film and the third insulating film between the fifth step and the sixth step.

This and other advantages of the present invention will become apparent to those skilled in the art upon reading and understanding the following detailed description with reference to the accompanying figures.

### BRIEF DESCRIPTION OF THE DRAWINGS

Figure **1** is a cross-sectional view showing a structure of a non-volatile semiconductor storage device of a first embodiment of the present invention.
Figure **2** is a graph showing the constant current stress-charge to breakdown (Qbd) characteristics of a functional insulating film in the non-volatile semiconductor storage device of the first embodiment of the present invention, which is represented by the relationship between the tilt angle of the side face including the functional insulating film formed by thermal oxidation in the step portion of the semiconductor substrate and the constant current stress-charge to breakdown (Qbd) of the functional insulating film.
Figures **3A** to **3C** are cross sectional views of a process sequence showing a method for producing a non-volatile semiconductor storage device of the first embodiment of the present invention.
Figures **4A** to **4C** are cross sectional views of a process sequence showing a method for producing a non-volatile semiconductor storage device of the first embodiment of the present invention.
Figure **5** is a cross sectional view showing a method for producing a non-volatile semiconductor storage device of the first embodiment of the present invention.
Figure **6** is a perspective view showing a non-volatile semiconductor storage device of the first embodiment of the present invention.
Figure **7** is a graph showing the constant current stress-charge to breakdown (Qbd) characteristics of a non-volatile semiconductor storage device of a second embodiment of the present invention, which is represented by the dependence of the constant current stress-charge to breakdown (Qbd) on the tilt angle of the step portion when an oxide film (HTO film) formed by a high temperature CVD method is used as the functional insulating film.
Figure **8** is a cross-sectional view showing a structure of a non-volatile semiconductor storage device of a second embodiment of the present invention.
Figures **9A** to **9C** are cross sectional views of a process sequence showing a method for producing a non-volatile semiconductor storage device of the second embodiment of the present invention.
Figures **10A** to **10C** are cross sectional views of a process sequence showing a method for producing a non-volatile semiconductor storage device of the second embodiment of the present invention.
Figures **11A** to **11C** are cross sectional views showing a method for producing a non-volatile semiconductor storage device of the second embodiment of the present invention.
Figure **12** is a perspective view showing a structure of a non-volatile semiconductor storage device of a third embodiment of the present invention.
Figures **13A** to **13C** are cross sectional views of a process sequence showing a method for producing a non-volatile semiconductor storage device of a third embodiment of the present invention.
Figures **14A** to **14C** are cross sectional views of a process sequence showing a method for producing a non-volatile semiconductor storage device of the third embodiment of the present invention.
Figures **15A** to **15C** are cross sectional views showing a method for producing a non-volatile semiconductor storage device of the third embodiment of the present invention.
Figure **16** is a cross sectional view showing a method for producing a non-volatile semiconductor storage device of the third embodiment of the present invention.
Figure **17** is a cross-sectional view showing a conventional split gate non-volatile semiconductor storage device.

### DETAILED DESCRIPTION OF THE INVENTION

### First Embodiment

A first embodiment of the present invention will be described with reference to the accompanying drawings.

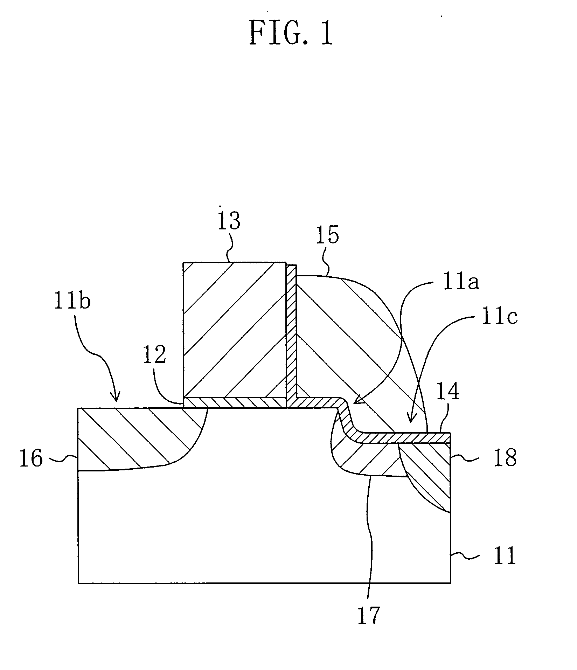

Figure **1** shows a cross-sectional structure of a non-volatile semiconductor storage device of a first embodiment of the present invention. As shown in Figure **1**, a step portion **11a** is provided in an upper portion of a semiconductor substrate **11** made of, for example, silicon (Si), and the step portion **11a** separates a first region **11b** that is the upper level thereof from a second region **11c** that is the lower level thereof.

A control gate electrode **13** made of, for example, polysilicon is formed on the first region **11b** of the semiconductor substrate **11** via a gate insulating film **12** made of, for example, silicon oxide.

A functional insulating film **14** made of, for example, silicon oxide is formed on the side face of the control gate electrode **13** on the side of the step portion **11a** and on the first region **11b,** the step portion **11a,** and the second region **11c,** and a floating gate electrode **15** made of, for example, polysilicon is formed on the functional insulating film **14** so as to straddle the step portion **11a.** The functional insulating film **14** serves as a capacitance insulating film in a portion that is opposed to the control gate electrode **13,** and serves as a tunnel insulating film in a portion that is opposed to the semiconductor substrate **11.**

A source diffusion layer **16** is formed to the side face of the control gate electrode **13** in the first region **11b** of the semiconductor substrate **11.** An n-type low concentration drain diffusion layer **17** is formed below the floating gate electrode **15** in the second region **11c** of the semiconductor substrate **11,** and a high concentration drain diffusion layer **18** is formed outside the low concentration drain diffusion layer **17.**

The first embodiment is characterized in that the side face of the step portion **11a** forms an obtuse angle with respect to the upper surface of the second region **11c,** and that the functional insulating film **14** has a substantially uniform thickness of about 9 nm to 11 nm at least on the step portion **11a**.

As a result of various examinations regarding the angle formed by the step portion **11a** with respect to the upper surface of the second region **11c** by the inventors of the present application, it has been found that the angle is preferably about 100° or more, more preferably about 110° or more and about 130° or less.

Hereinafter, the relationship between the tilt angle of the step portion **11a** and the quality of the film of the functional insulating film (tunnel film) will be described.

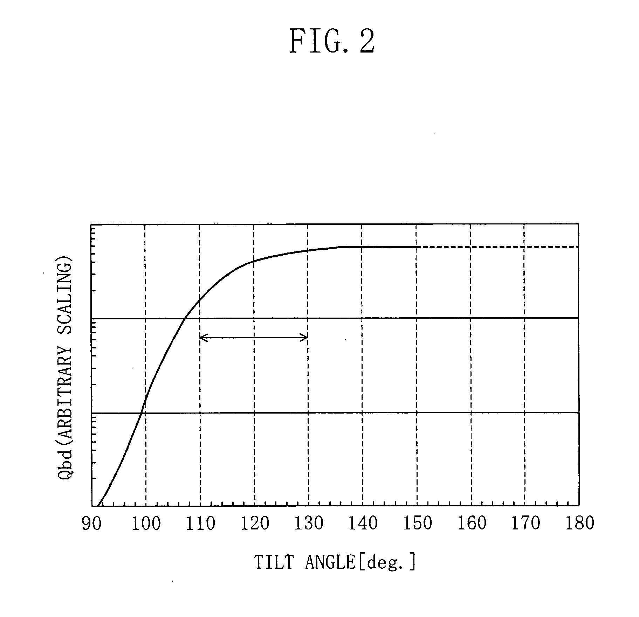

Figure **2** shows the results of experiments regarding the relationship between the tilt angle of the side face including the functional insulating film **14** formed by thermal oxidation in the step portion **11a** of the semiconductor substrate **11** and the constant current stress-charge to breakdown (CCS-Qbd) of the function insulating film **14** according to the first embodiment. In this embodiment, the functional insulating film **14** is a thermal oxide film having a thickness of 9 nm.

The tilt angle of the step portion **11a** with respect to the upper surface of the second region **11c** is formed in a range from 120° to 150° by using chemical dry etching (CDE) and changing the flow ratio of oxygen (O₂) and fluorocarbon (CF₄), which are etching gases for CDE, to change the etching selection ratio. The tilt angle of 120° or less is formed by reactive ion etching (RIE).

When the step portion **11a** is subjected to thermal oxidation, the semiconductor substrate **11** is rounded by the stress of the thermal oxidation, so that the tilt angle is different between after the formation of the step portion **11a** and after the thermal oxidation. In the first embodiment, it is confirmed that the tilt angle after the thermal oxidation is reduced by about 10 degrees from the tilt angle after the formation of the step portion **11a**.

As shown in Figure **2,** the relationship between the tilt angle and the constant current stress-charge to breakdown differs greatly between the left and the right of the tilt angle of 110° in Figure **2.** More specifically, in the region where the tilt angle is more than 110°, a constant current stress-charge to breakdown substantially equal to that of the tunnel film formed on a flat substrate without the step portion **11a** can be maintained. On the other hand, in a region where the tilt angle is 110° or less, the constant current stress-charge to breakdown is sharply reduced as the tilt angle is reduced.

This seems to be caused for the following reason. In a region where the tilt angle is small (close to a right angle), the thickness of the film in the corners on the upper level and the lower level of the step portion **11a** in the functional insulating film **14** is locally small, so that the stress due to the electrical field concentrates thereon and the quality of the film is deteriorated. As a result, the constant current stress-charge to breakdown is reduced rapidly. On the other hand, when the tilt angle is as large as 110° or more, the thickness of the film in the corners in the step portion **11a** in the functional insulating film **14** is not small, so that the quality of the film is improved and stabilized.

The constant current stress-charge to breakdown indicates the reliability of the functional insulating film **14**. For the non-volatile semiconductor storage device of the first embodiment, a constant current stress-charge to breakdown equal to the thermal oxide film formed on a flat substrate without the step portion **11a** is required. Accordingly, the tilt angle of the step portion **11a** that satisfies this condition is 110° or more.

On the other hand, when the tilt angle after the formation of the step portion **11a** is large, arsenic (As) ions, which are impurities, are implanted not only in the second region **11c,** which is the lower level of the step portion **11a,** but also in the side face of the step portion **11a,** when forming the n-type low concentration drain region **17.** If arsenic ions are implanted in the side face of the step portion **11a** and an n-type region is formed, implantation of electrons to be written in the floating gate electrode **15** via the tunnel film on the side face of the step portion **11a** is suppressed. Therefore, it is preferable that the tilt angle of the side face of the step portion **11a** is small for improving the write rate.

These findings lead to the conclusion that the tilt angle after the formation of the functional insulating film **14** in the step portion **11a** of the non-volatile semiconductor storage device according to the first embodiment is preferably about 110° or more and about 130° or less, and more preferably 120°, in order to improve the reliability as the tunnel film and the write rate of electrons at the same time.

Hereinafter, a method for producing a non-volatile semiconductor storage device according to the first embodiment having the above-described structure of the present invention will be described with reference to the accompanying drawings.

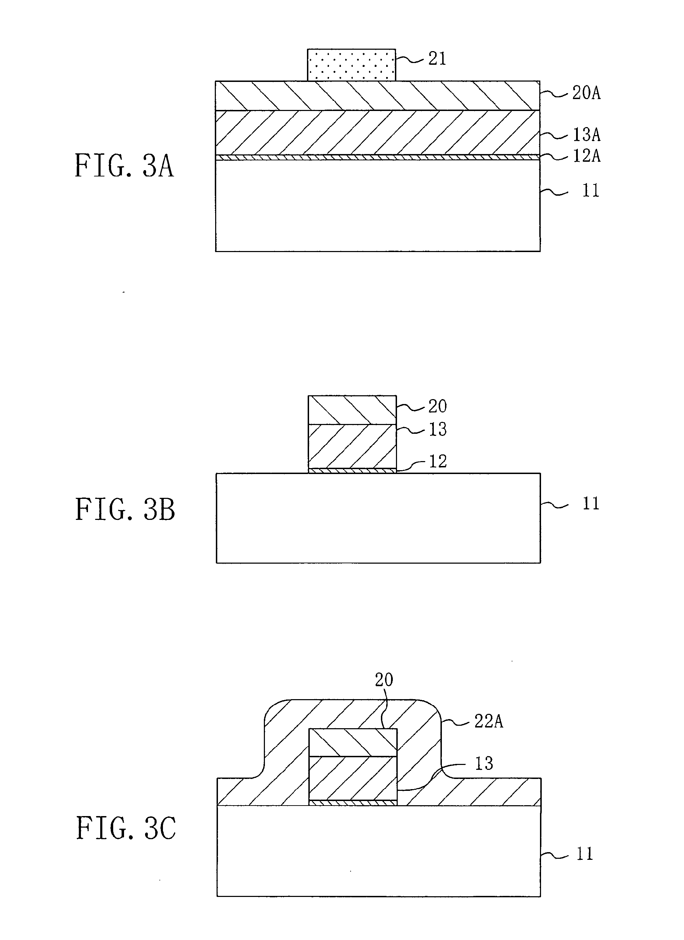

Figures **3A** through **5** show a process sequence of a method for producing a non-volatile semiconductor storage device according to the first embodiment of the present invention.

First, as shown in Figure **3A,** a gate insulating film forming film **12A** made of silicon oxide having a thickness of about 9 nm on the principle surface of a semiconductor substrate **11** by thermal oxidation. Then, a gate electrode forming film **13A** made of polycrystalline silicon having a thickness of about 200 nm to 300 nm and a protective film **20A** made of silicon nitride or silicon oxide having a thickness of about 100 nm to 200 nm are formed sequentially on the gate insulating film forming film **12A** by chemical vapor deposition (CVD). Thereafter, a first resist mask **21** having a control gate electrode pattern is formed on the protective film **20A** by lithography.

Next, as shown in Figure **3B,** using the formed first resist mask **21,** anisotropic dry etching is performed with respect to the protective film **20A,** the gate electrode forming film **13A,** and the gate insulating film forming film **12A** so that a patterned protective film **20,** a control gate electrode **13,** and a gate insulating film **12** are obtained.

Next, as shown in Figure **3C,** the first resist mask **21** is removed, and then a BPSG (boron phosphide silicate glass) film **22A** having a thickness of about 30 nm to 50 nm is deposited over the entire surface of the semiconductor substrate **11** including the control gate electrode **13** and the protective film **20** by CVD.

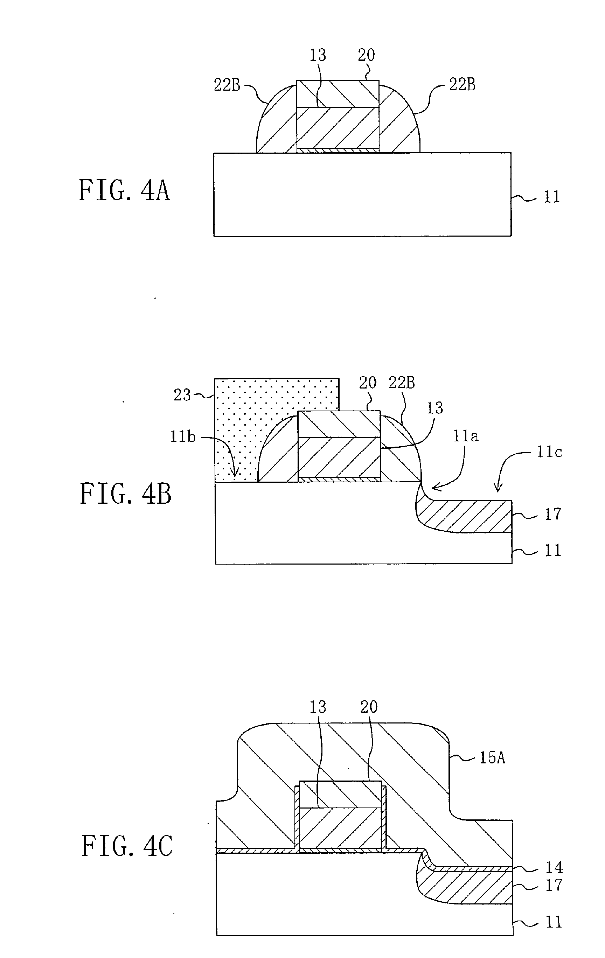

As shown in Figure **4A,** etchback is performed with respect to the deposited BPSG film **22A** by anisotropic dry etching so that side walls **22B** made of the BPSG film **22A** are formed on the side faces of the control gate electrode **13.**

Next, as shown in Figure **4B,** a second resist mask **23** is formed on the side of the source forming region on the semiconductor substrate **11** including the side portion of the protective film **20,** and isotropic dry etching is performed with respect to the semiconductor substrate **11,** using the formed second resist mask **23,** the protective film **20,** and the side walls **22B** as a mask, for example, with CF₄ or NF₃ as the etching gas. Then, the first region **11b** on which the side walls **22B** are located, the second region **11c** formed by etching the first region **11b,** and the step portion **11a** connecting the first region **11b** and the second region **11c** are formed such that the angle formed between the side face of the step portion **11a** and the upper surface of the second region **11c** is about 110° or more and about 130° or less. The depth of the second region **11c** is about 30 nm.

As methods for improving the quality of the functional insulating film **14** on the step portion **11a,** the following methods other than increasing the tilt angle by chemical dry etching can be used: The step portion **11a** is formed on the semiconductor substrate **11** by dry etching, and then the tilt angle of the step portion **11a** is increased by wet etching, for example, with an alkali solution such as ammonium hydroxide (NH₄OH) as the etchant; or the step portion **11a** is formed on the semiconductor substrate **11** by dry etching, and then the semiconductor substrate **11** is subjected to thermal oxidation to round the step portion **11a,** and then the thermal oxide film is removed by wet etching to increase the tilt angle of the step portion **11a.** Either one of the above-described methods can be used to improve the quality of the functional insulating film **14,** which is formed after the formation of the step portion **11a.**

Then, with the second resist mask **23,** the protective film **20** on the control gate electrode **13** and the side walls **22B** as a mask, arsenic ions are implanted on the semiconductor substrate **11,** for example, at an implantation dose amount of 0.5 × 10¹⁴ cm⁻² to 5 × 10¹⁴ cm⁻² and an implantation energy of about 10 keV to form an n-type low concentration drain diffusion layer **17** in the drain forming region.

Next, as shown in Figure **4C,** after the second resist mask **23** and the side walls **22B** are removed, a functional insulating film **14** having a thickness of about 9 nm is formed in the exposed portion of the semiconductor substrate **11** and the side face of the control gate electrode **13** by thermal oxidation (wet oxidation) at 850°C for about 10 minutes with oxygen gas and hydrogen gas. Then, a floating gate electrode forming film **15A** made of polycrystalline silicon having a thickness of about 100 nm is deposited over the entire surface including the control gate electrode **13** and the protective film **20** on the functional insulating film **14** by CVD.

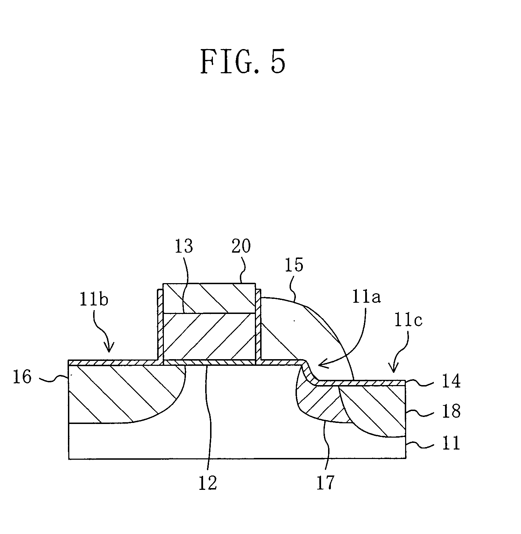

Next, as shown in Figure **5,** etchback is performed with respect to the deposited floating gate electrode forming film **15A** by anisotropic dry etching to form a floating gate electrode **15** made of the floating gate electrode forming film **15A** on the side face of the control electrode **13** on the side of the step portion **11a** and in the second region **11c** including the step portion **11a** on the functional insulating film **14.** Thus, the floating gate electrode **15** straddles the step portion **11a** via the functional insulating film **14** serving as the tunnel insulating film, and is opposed to the control gate electrode **13** via the functional insulating film **14** serving as the capacitance insulating film at their side faces. Thereafter, arsenic ions are implanted in the semiconductor substrate **11** with the protective film **20** on the control gate electrode **13** and the floating gate electrode **15** as a mask, so that a source diffusion layer **16** is formed in the first region **11b** of the semiconductor substrate **11,** and a high concentration drain diffusion layer **18** that is connected to the low concentration drain region **17** is formed in the second region **11c** of the semiconductor substrate **11.**

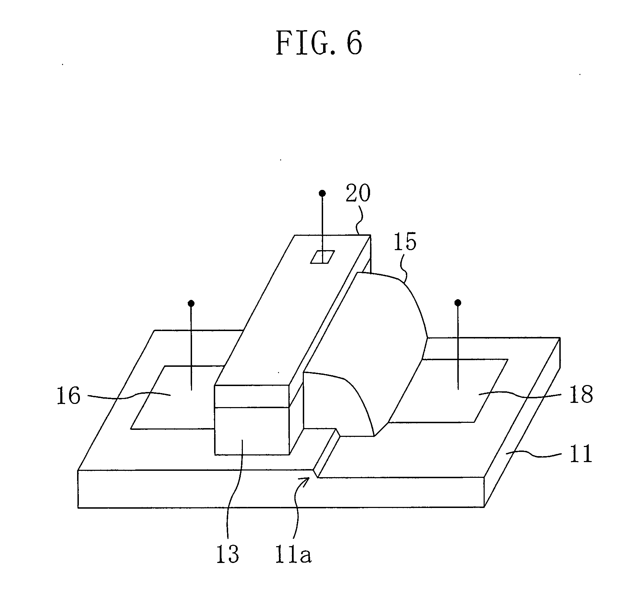

Thereafter, predetermined lines and interlayer insulating films are formed, although not shown, so that one memory element of the non-volatile semiconductor storage device of the first embodiment, as shown in the perspective view of Figure **6,** can be obtained.

### Second embodiment

Hereinafter, a second embodiment of the present invention will be described.

In order to make the thickness of the functional insulating film serving as the tunnel insulating film uniform, the side face of the step portion is formed so as to have a tilt angle of 100° or more. Other than this, the inventors of the present application also have found that the thickness can be substantially uniform by using an insulating film obtained by deposition as the functional insulating film, even if the tilt angle of the side face of the step portion is substantially a right angle.

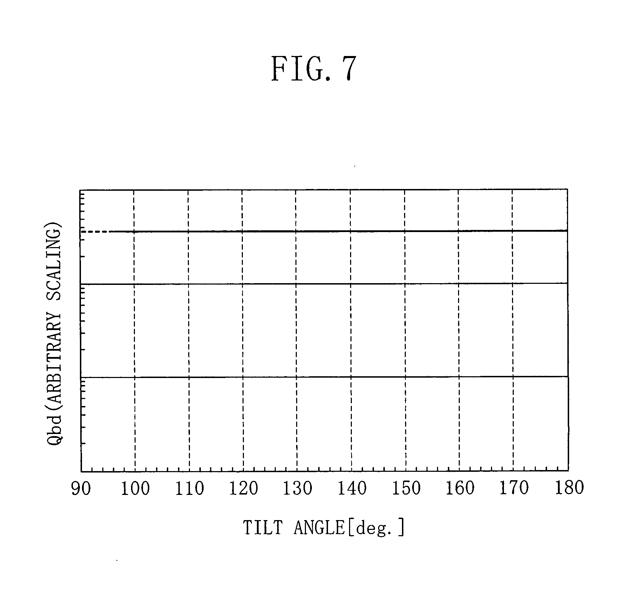

Figure **7** shows the dependence of the constant current stress-charge to breakdown on the tilt angle of the step portion when an oxide film formed by high temperature CVD instead of thermal oxidation, a so-called HTO (high temperature oxide) film, is used as the functional insulating film.

As shown in Figure **7**, when an oxide film formed by deposition (hereinafter, referred to as "deposited oxide film") is used as the functional insulating film, the constant current stress-charge to breakdown does not depend on the tilt angle of the step portion. This is because the thickness of the deposited oxide film is not small locally in the corners of the step portion as opposed to the thermal oxide film, even if the tilt angle of the step portion is small (close to 90°). In general, the deposited oxide film has a smaller density of silicon that is oxidized than the thermal oxide film, and therefore a dense oxide film can hardly be obtained, so that more defects occur in the film.

Therefore, in the second embodiment, after a deposited oxide film is formed, a thermal oxide film is formed via the deposited oxide film on the side of the substrate. Thus, a multilayered film including the thermal oxide film and the deposited oxide film is formed as the functional insulating film in order to prevent the non-uniformity of the thickness arising from the corners of the step portion in the functional insulating film and improve the quality of the film.

Hereinafter, a specific example of a non-volatile semiconductor storage device of the present invention will be described with reference to the accompanying drawings.

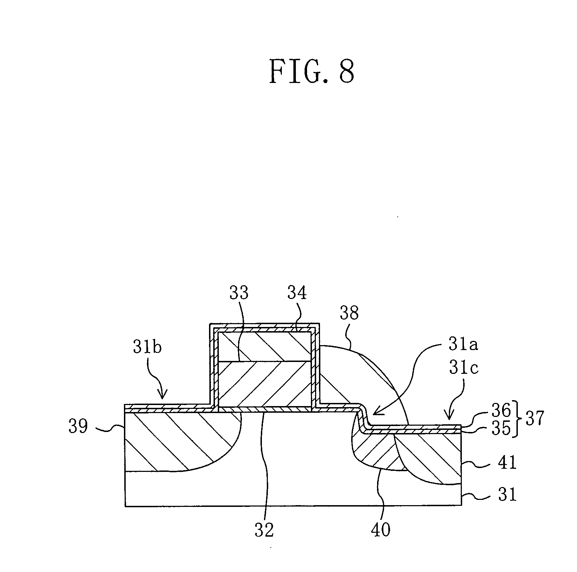

Figure **8** is a cross-sectional structure of a non-volatile semiconductor storage device of the second embodiment of the present invention. As shown in Figure **8,** a step portion **31a** is formed in an upper portion of a semiconductor substrate **31** made of, for example, silicon, and the step portion **11a** separates a first region **31b** that is the upper level thereof from a second region **31c** that is the lower level thereof.

A control gate electrode **33** made of, for example, polysilicon is formed on the first region **31b** of the semiconductor substrate **31** via a gate insulating film **32** made of, for example, silicon oxide. A protective film **34** for protecting the control gate electrode **33** made of, for example, silicon nitride or silicon oxide is formed on the control gate electrode **33.**

A functional insulating film **37** including a thermal oxide film **35** and a deposited oxide film **36,** for example, both of which are made of silicon oxide, is formed on the control gate electrode **33,** the first region **31b,** the step portion **31a,** and the second region **31c.**

A floating gate electrode **38** made of, for example, polysilicon is formed on the functional insulating film **37.** The functional insulating film **37** serves as a capacitance insulating film in a portion that is opposed to the control gate electrode **33,** and serves as a tunnel insulating film in a portion that is opposed to the semiconductor substrate **31.**

A source diffusion layer **39** is formed to the side face of the control gate electrode **33** in the first region **31b** of the semiconductor substrate **31.** An n-type low concentration drain diffusion layer **40** is formed below the floating gate electrode **38** in the second region **31c** of the semiconductor substrate **31,** and a high concentration drain diffusion layer **41** is formed outside the low concentration drain diffusion layer **40.**

The second embodiment is characterized in that the functional insulating film **37** has a multilayered structure including the thermal oxide film **35** and the deposited oxide film **36** and has a substantially uniform thickness of about 9 nm to 11 nm on the step portion **31a.**

Hereinafter, a method for producing a non-volatile semiconductor storage device according to the second embodiment having the above-described structure of the present invention will be described with reference to the accompanying drawings.

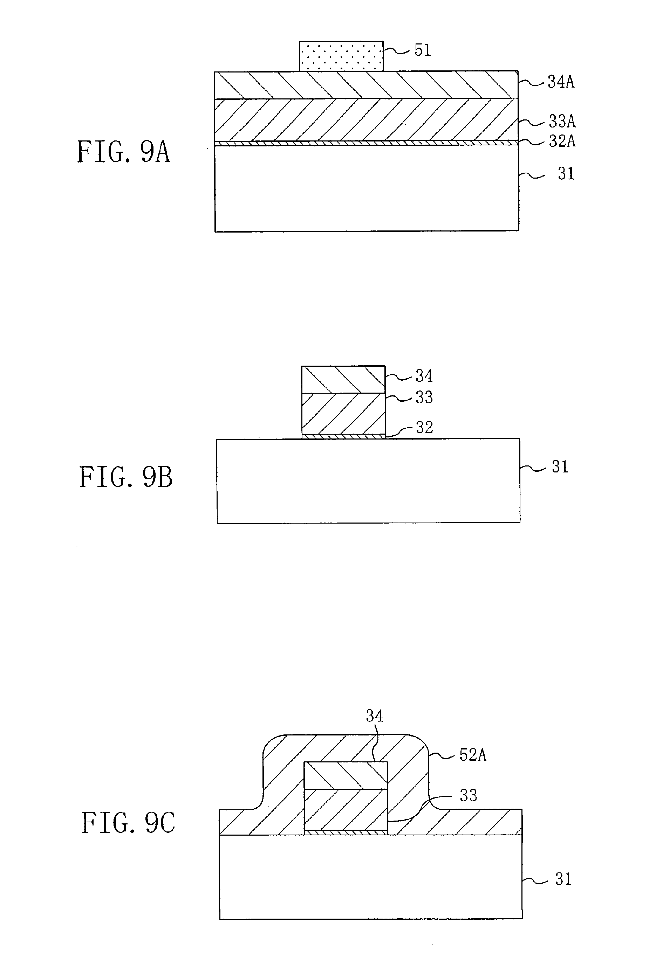

Figures **9A** through **11C** show a process sequence of a method for producing a non-volatile semiconductor storage device according to the second embodiment of the present invention.

First, as shown in Figure **9A,** a gate insulating film forming film **32A** made of silicon oxide having a thickness of about 9 nm on the principle surface of a semiconductor substrate **31** by thermal oxidation. Then, a gate electrode forming film **33A** made of polycrystalline silicon having a thickness of about 200 nm to 300 nm and a protective film **34A** made of silicon nitride having a thickness of about 100 nm to 200 nm are formed sequentially on the gate insulating film forming film **32A** by CVD. Thereafter, a first resist mask **51** having a control gate electrode pattern is formed on the protective film **34A** by lithography.

Next, as shown in Figure **9B,** using the formed first resist mask **51,** anisotropic dry etching is performed with respect to the protective film **34A,** the gate electrode forming film **33A** and the gate insulating film forming film **32A** so that a patterned protective film **34,** a control gate electrode **33,** and a gate insulating film **32** are obtained.

Next, as shown in Figure **9C,** the first resist mask **51** is removed, and then a BPSG film **52A** having a thickness of about 30 nm to 50 nm is deposited over the entire surface of the semiconductor substrate **31** including the control gate electrode **33** by CVD.

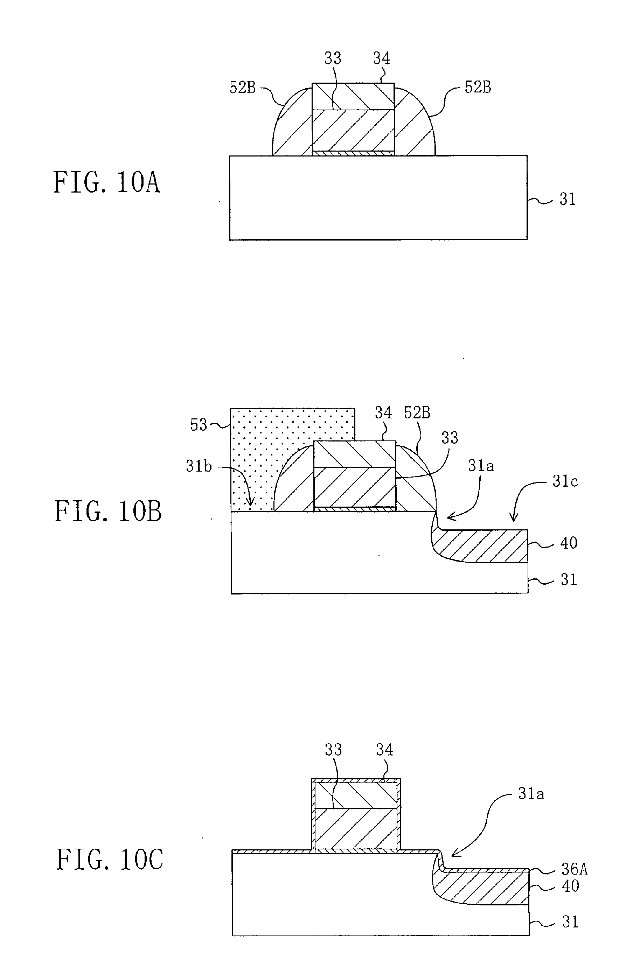

As shown in Figure **10A,** etchback is performed with respect to the deposited BPSG film **52A** by anisotropic dry etching so that side walls **52B** made of the BPSG film **52A** are formed on the side face of the control gate electrode **33.**

Next, as shown in Figure **10B,** a second resist mask **53** is formed on the side of the source forming region on the semiconductor substrate **31** including the side portion of the protective film **34,** and for example, isotropic dry etching is performed with respect to the semiconductor substrate **31,** using the formed second resist mask **53,** the protective film **34,** and the side walls **52B** as a mask, to form the first region **31b** on which the side walls **52B** are located, the second region **31c** formed by etching the first region **31b,** and the step portion **31a** connecting the first region **31b** and the second region **31c.** The depth of the second region **31c** is about 30 nm. Thereafter, with the second resist mask **53,** and the protective film **34** on the control gate electrode **33** and the side walls **52B** as a mask, arsenic ions are implanted on the semiconductor substrate **31,** for example, at an implantation dose amount of about 0.5 × 10¹⁴ cm⁻² to 5 × 10¹⁴ cm⁻² and an implantation energy of about 10 keV to form an n-type low concentration drain diffusion layer **40** in the drain forming region.

Next, as shown in Figure **10C,** after the second resist mask **53** and the side walls **52B** are removed, a deposited oxide film **36A** having a thickness of about 5 nm made of, for example, HTO is deposited over the entire surface of the semiconductor substrate **31** including the control gate electrode **33** and the protective film **34** by CVD.

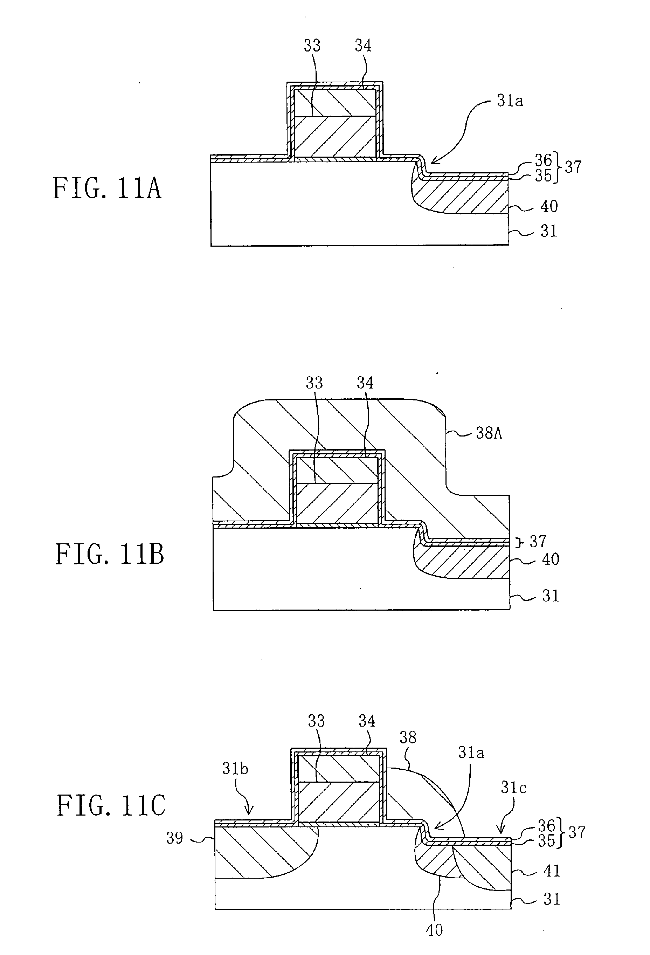

Next, as shown in Figure **11A,** a thermal oxide film **35** having a thickness of about 7 nm is formed at the interface between the deposited oxide film **36A** and the semiconductor substrate **31** and the control gate electrode **33.** Thus, the oxidation density of the deposited oxide film **36A** is increased so that a deposited oxide film **36** having improved film quality can be obtained, and at the same time, a functional insulating film **37** having a total thickness of about 9 nm to 11 nm including the deposited oxide film **36** and the thermal oxide film **35** therebelow is formed.

In Figure **10C,** the deposited oxide film **36A** may be an oxynitride film. In Figure **11A,** nitrogen monoxide (NO), nitrous oxide (N₂O), or ammonia (NH₃) gas may be added to the ambient for thermal oxidation to form an oxynitride film as the deposited oxide film **36.** With this, the breakdown voltage property of the functional insulating film **37** can be improved.

Next, as shown in Figure **11B,** a floating gate electrode forming film **38A** made of polycrystalline silicon having a thickness of about 100 nm is deposited over the entire surface of the functional insulating film **37** including the control gate electrode **33** and the protective film **34** by CVD.

Next, as shown in Figure **11C,** etchback is performed with respect to the deposited floating gate electrode forming film **38A** by anisotropic dry etching to form a floating gate electrode **38** made of the floating gate electrode forming film **38A** on the side face of the control electrode **33** on the side of the step portion **31a** and in the second region **31c** including the step portion **31a** on the functional insulating film **37.** Thus, the floating gate electrode **38** straddles the step portion **31a** via the functional insulating film **37** serving as the tunnel insulating film, and is opposed to the control gate electrode **33** via the functional insulating film **37** serving as the capacitance insulating film at their side faces. Thereafter, arsenic ions are implanted in the semiconductor substrate **31** with the protective film **34** on the control gate electrode **33** and the floating gate electrode **38** as a mask, so that a source diffusion layer **39** is formed in the first region **31b** of the semiconductor substrate **31,** and a high concentration drain diffusion layer **41** that is connected to the low concentration drain region **40** is formed in the second region **31c** of the semiconductor substrate **31.**

Thereafter, predetermined lines and interlayer insulating films (not shown) are formed, so that one memory element of the non-volatile semiconductor storage device of the second embodiment can be obtained.

As described above, according to the second embodiment, the functional insulating film **37** serving as the tunnel insulating film on the step portion **31a** provided in an upper portion of the semiconductor substrate **31** is constituted by the thermal oxide film **35** and the deposited oxide film **36,** and therefore even if the tilt angle of the side face of the step portion **31a** is an obtuse angle of less than 100 , the functional insulating film **37** can be prevented from being thin locally in the corners of the step **31a.** Therefore, the film quality of the functional insulating film **37** can be improved and thus the reliability of the functional insulating film **37** can be improved.

If an annealing treatment is formed in a non-oxidative ambient such as nitrogen gas at a temperature of, for example 800 C to 900 C for about 10 to 30 minutes after the process for forming the thermal oxide film as shown in Figure **11A,** the film quality of the functional insulating film **37** can be further improved with the thickness thereof maintained.

### Third Embodiment

Hereinafter, a third embodiment of the present invention will be described.

In the above-described second embodiment, after the deposited oxide film is formed in the step portion, the semiconductor substrate is thermally oxidized via the deposited oxide film to form the function insulating film so that the influence of the corners of the step portion on the functional insulating film can be eliminated.

In the third embodiment, in order to reduce further the influence of the corners of the step portion on the functional insulating film, a thin first thermal oxide film is formed on the surface of the step portion with a rapid thermal process (RTP) of thermal oxidation methods, and then a deposited oxide film is deposited on the formed first thermal oxide film, and further a second thermal oxide film is formed on the first oxide film on the side of the substrate via the deposited oxide film.

Hereinafter, a specific example of a non-volatile semiconductor storage device of the present invention will be described with reference to the accompanying drawings.

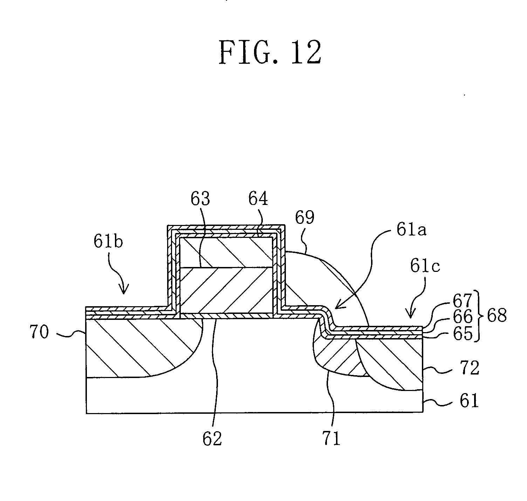

Figure **12** is a cross-sectional structure of a non-volatile semiconductor storage device of the third embodiment of the present invention. As shown in Figure **12,** a step portion **61a** is formed in an upper portion of a semiconductor substrate **61** made of, for example, silicon, and the step portion **61a** separates a first region **61b** that is the upper level thereof from a second region **61c** that is the lower level thereof.

A control gate electrode **63** made of, for example, polysilicon is formed on the first region **61b** of the semiconductor substrate **61** via a gate insulating film **62** made of, for example, silicon oxide. A protective film **64** for protecting the control gate electrode **63** made of, for example, silicon nitride or silicon oxide is formed on the control gate electrode **63.**

A functional insulating film **68** including a second thermal oxide film **65,** a first thermal oxide film **66** and a deposited oxide film **67,** all of which are made of, for example, silicon oxide, is formed on the control gate electrode **63,** the first region **61b,** the step portion **61a,** and the second region **61c.**

A floating gate electrode **69** made of, for example, polysilicon is formed on the functional insulating film **68.** The functional insulating film **68** serves as a capacitance insulating film in a portion that is opposed to the control gate electrode **63,** and serves as a tunnel insulating film in a portion that is opposed to the semiconductor substrate **61.**

A source diffusion layer **70** is formed to the side face of the control gate electrode **63** in the first region **61b** of the semiconductor substrate **61.** An n-type low concentration drain diffusion layer **71** is formed below the floating gate electrode **69** in the second region **61c** of the semiconductor substrate **61,** and a high concentration drain diffusion layer **72** is formed outside the low concentration drain diffusion layer **71.**

The third embodiment is characterized in that the functional insulating film **68** has a multilayered structure including the second thermal oxide film **65,** the first thermal oxide film **66** and the deposited oxide film **67** and has a substantially uniform thickness of about 9 nm to 11 nm on the step portion **61a.**

Hereinafter, a method for producing a non-volatile semiconductor storage device according to the third embodiment having the above-described structure will be described with reference to the accompanying drawings.

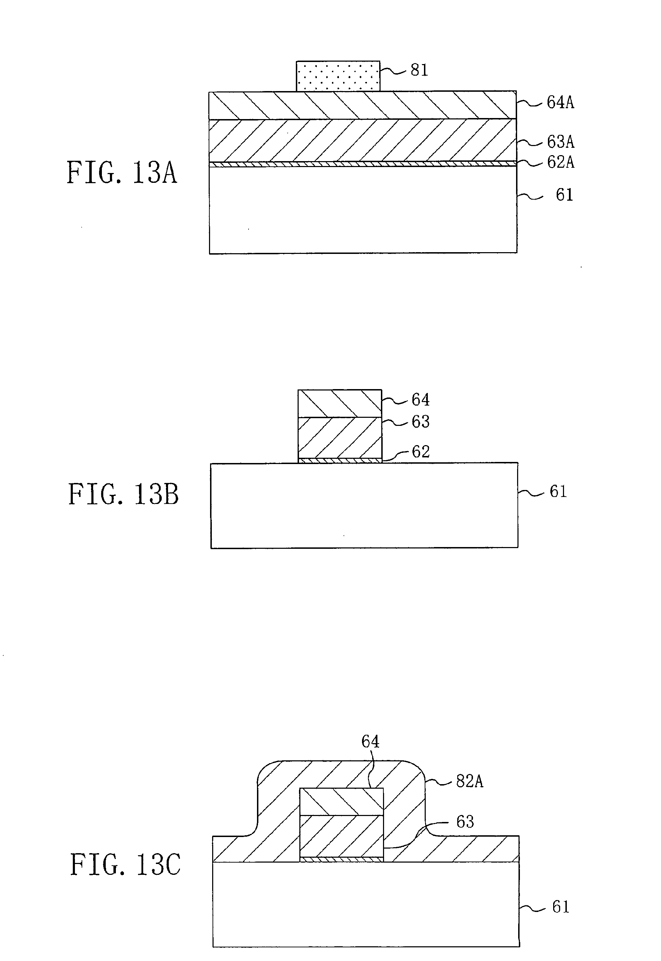

Figures **13A** through **16** show a process sequence of a method for producing a non-volatile semiconductor storage device according to the third embodiment of the present invention.

First, as shown in Figure **13A,** a gate insulating film forming film **62A** made of silicon oxide having a thickness of about 9 nm on the principle surface of a semiconductor substrate **61** by thermal oxidation. Then, a gate electrode forming film **63A** made of polycrystalline silicon having a thickness of about 200 nm to 300 nm and a protective film **64A** made of silicon nitride having a thickness of about 100 nm to 200 nm are formed sequentially on the gate insulating film forming film **62A** by CVD. Thereafter, a first resist mask **81** having a control gate electrode pattern is formed on the protective film **64A** by lithography.

Next, as shown in Figure **13B,** using the formed first resist mask **81,** anisotropic dry etching is performed with respect to the protective film **64A,** the gate electrode forming film **63A** and the gate insulating film forming film **62A** so that a patterned protective film **64,** a control gate electrode **63,** and a gate insulating film **62** are obtained.

Next, as shown in Figure **13C,** the first resist mask **81** is removed, and then a BPSG film **82A** having a thickness of about 30 nm to 50 nm is deposited over the entire surface of the semiconductor substrate **61** including the control gate electrode **63** by CVD.

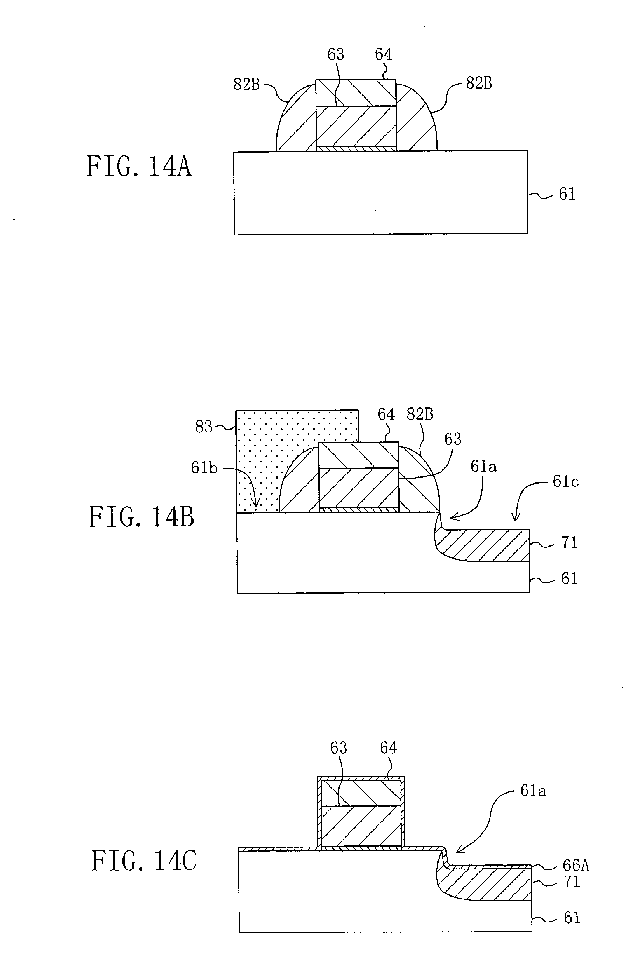

As shown in Figure **14A,** etchback is performed with respect to the deposited BPSG film **82A** by anisotropic dry etching so that side walls **82B** made of the BPSG film **82A** are formed on the side face of the control gate electrode **63.**

Next, as shown in Figure **14B,** a second resist mask **83** is formed on the side of the source forming region on the semiconductor substrate **61** including the side portion of the protective film **64,** and for example, isotropic dry etching is performed with respect to the semiconductor substrate **61,** using the formed second resist mask **83,** the protective film **64,** and the side walls **82B** as a mask, to form the first region **61b** on which the side walls **82B** are located, the second region **61c** formed by etching the first region **61b,** and the step portion **61a** connecting the first region **61b** and the second region **61c.** The depth of the second region **61c** is about 30 nm. Thereafter, with the second resist mask **83,** the protective film **64** on the control gate electrode **63** and the side walls **82B** as a mask, arsenic ions are implanted into the semiconductor substrate **61,** for example, at an implantation dose amount of 0.5 × 10¹⁴ cm⁻² to 5 × 10¹⁴ cm⁻² and an implantation energy of about 10 keV to form an n-type low concentration drain diffusion layer **71** in the drain forming region.

Next, as shown in Figure **14C,** after the second resist mask **83** and the side walls **82B** are removed, a first thermal oxide film **66A** having a thickness of about 2 nm to 5 nm is formed in the exposed portion of the semiconductor substrate **61** and the side face of the control gate electrode **63** is formed by thermal oxidation by a rapid thermal process.

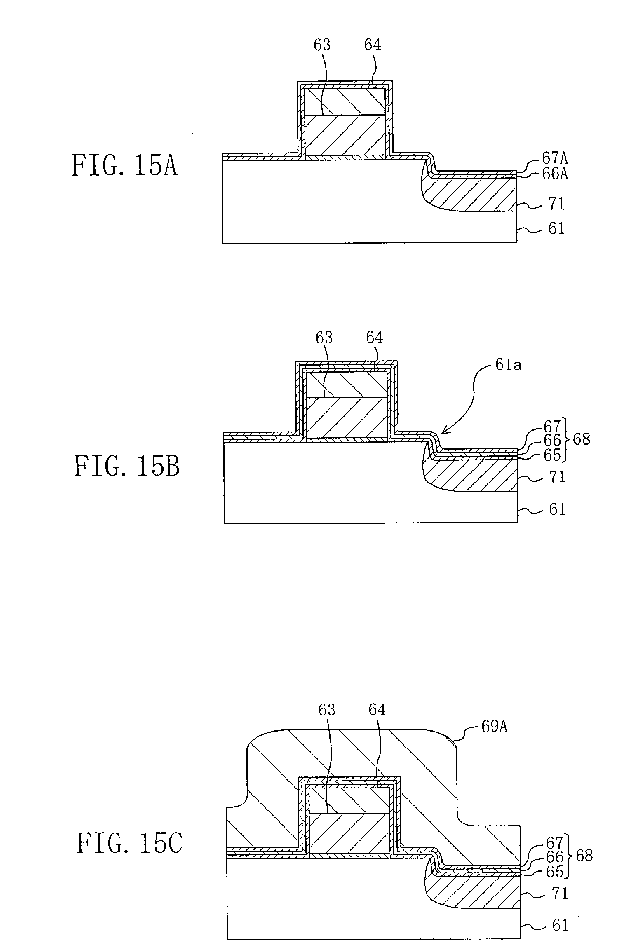

Then, as shown in Figure **15A,** a deposited oxide film **67A** having a thickness of about 3 nm made of, for example, HTO is deposited over the entire surface of the first thermal oxide film **66A** by CVD.

Next, as shown in Figure **15B,** a second thermal oxide film **65** having a thickness of about 7 nm is formed at the interface between the first thermal oxide film **66A** and the semiconductor substrate **61** and the control gate electrode **63.** Thus, the oxidation density of the deposited oxide film **67A** and the first thermal oxide film **66A** is increased so that a deposited oxide film **67** and a first thermal oxide film **66** having improved film quality can be obtained, and at the same time, a functional insulating film **68** having a total thickness of about 9 nm to 11 nm including the deposited oxide film **67,** the first thermal oxide film **66** and the second thermal oxide film **65** therebelow is formed.

In Figure **15A,** the deposited oxide film **67A** may be an oxynitride film. In Figure **15B,** nitrogen monoxide, nitrous oxide, or ammonia gas may be added to the ambient for thermal oxidation to form an oxynitride film as the deposited oxide film **67.** With this, the breakdown voltage property of the functional insulating film **68** can be improved.

Next, as shown in Figure **15C,** a floating gate electrode forming film **69A** made of polycrystalline silicon having a thickness of about 100 nm is deposited over the entire surface of the functional insulating film **68** including the control gate electrode **63** and the protective film **64** by CVD.

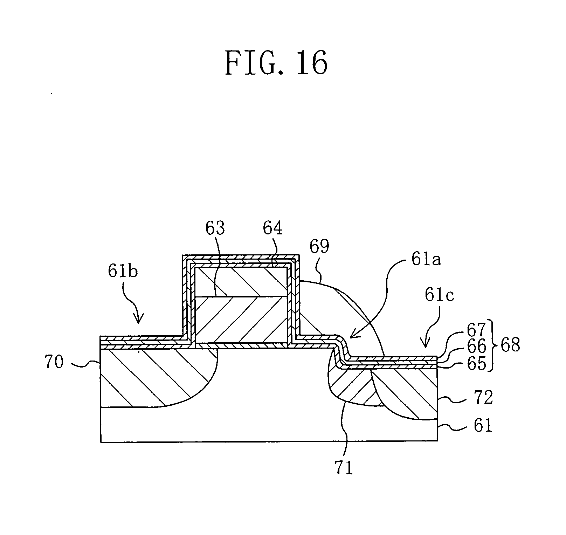

Next, as shown in Figure **16,** etchback is performed with respect to the deposited floating gate electrode forming film **69A** by anisotropic dry etching to form a floating gate electrode **69** made of the floating gate electrode forming film **69A** on the side face of the control electrode **63** on the side of the step portion **61a** and in the second region **61c** including the step portion **61a** on the functional insulating film **68.** Thus, the floating gate electrode **69** straddles the step portion **61a** via the functional insulating film **69** serving as the tunnel insulating film, and is opposed to the control gate electrode **63** via the functional insulating film **68** serving as the capacitance insulating film at their side faces. Thereafter, arsenic ions are implanted in the semiconductor substrate **61** with the protective film **64** on the control gate electrode **63** and the floating gate electrode **69** as a mask, so that a source diffusion layer **70** is formed in the first region **61b** of the semiconductor substrate **61,** and a high concentration drain diffusion layer **72** that is connected to the low concentration drain region **71** is formed in the second region **61c** of the semiconductor substrate **61.**

Thereafter, predetermined lines and interlayer insulating films (not shown) are formed, so that one memory element of the non-volatile semiconductor storage device of the third embodiment can be obtained.

As described above, according to the third embodiment, the functional insulating film **68** serving as the tunnel insulating film on the step portion **61a** provided in an upper portion of the semiconductor substrate **61** is constituted by the second thermal oxide film **65,** the first thermal oxide film **66,** and the deposited oxide film **67,** and therefore even if the tilt angle of the side face of the step portion **61a** is an obtuse angle of less than 100 , the functional insulating film **68** can be prevented from being thin locally in the corners of the step **61a.** Therefore, the film quality of the functional insulating film **68** can be improved and thus the reliability of the functional insulating film **68** can be improved.

If an annealing treatment is formed in a non-oxidative ambient such as nitrogen gas at a temperature of, for example about 850 C for about 90 minutes after the process for forming the second thermal oxide film as shown in Figure **15B,** the film quality of the functional insulating film **68** can be further improved with the thickness thereof maintained.

The invention may be embodied in other forms without departing from the spirit or essential characteristics thereof. The embodiments disclosed in this application are to be considered in all respects as illustrative and not limiting. The scope of the invention is indicated by the appended claims rather than by the foregoing description, and all changes which come within the meaning and range of equivalency of the claims are intended to be embraced therein.

## Claims

1. A non-volatile semiconductor storage device comprising:
a semiconductor substrate provided with a step portion in an upper portion thereof, and having a first region that is an upper level of the step portion and a second region that is a lower level thereof;
a control gate electrode formed on the first region of the semiconductor substrate via a gate insulating film; and
a floating gate electrode formed on a side face of the control gate electrode on a side of the step portion and on the step portion via an insulating film;
wherein a side face of the step portion forms an obtuse angle with respect to an upper surface of the second region, and
the insulating film has a substantially uniform thickness on the step portion.

2. The non-volatile semiconductor storage device according to claim 1,
wherein an angle formed between the side face of the step portion and the upper surface of the second region is about 100° or more.

3. The non-volatile semiconductor storage device according to claim 1,
wherein an angle formed between the side face of the step portion and the upper surface of the second region is about 110° or more and about 130° or less.

4. The non-volatile semiconductor storage device according to claim 1,
wherein the insulating film is a thermal oxide film.

5. A non-volatile semiconductor storage device comprising:
a semiconductor substrate provided with a step portion in an upper portion thereof, and having a first region that is an upper level of the step portion and a second region that is a lower level thereof;
a control gate electrode formed on the first region of the semiconductor substrate via a gate insulating film; and
a floating gate electrode formed on a side face of the control gate electrode on a side of the step portion and on the step portion via a first insulating film and a second insulating film provided in this order from the substrate;
wherein the second insulating film is formed with a deposited film.

6. The non-volatile semiconductor storage device according to claim 5,
wherein the first insulating film is a thermal oxide film, and the second insulating film is an oxide film.

7. The non-volatile semiconductor storage device according to claim 5,
wherein the first insulating film is a thermal oxide film, and the second insulating film is an oxynitride film.

8. A non-volatile semiconductor storage device comprising:
a semiconductor substrate provided with a step portion in an upper portion thereof, and having a first region that is an upper level of the step portion and a second region that is a lower level thereof;
a control gate electrode formed on the first region of the semiconductor substrate via a gate insulating film; and
a floating gate electrode formed on a side face of the control gate electrode on a side of the step portion and on the step portion via a first insulating film, a second insulating film and a third insulating film provided in this order from the substrate;
wherein the third insulating film is formed with a deposited film.

9. The non-volatile semiconductor storage device according to claim 8,
wherein the first insulating film and the second insulating film are thermal oxide films, and the third insulating film is an oxide film.

10. The non-volatile semiconductor storage device according to claim 8,
wherein the first insulating film is a thermal oxide film, the second insulating film is an oxynitride film formed by thermal oxidation, and the third insulating film is an oxynitride film.

11. A method for producing a non-volatile semiconductor storage device comprising:
a first step of forming a gate insulating film and a gate electrode sequentially on a semiconductor substrate;
a second step of forming a side wall on a side face of the control gate electrode and then etching the semiconductor substrate using the formed side wall as a mask, thereby forming a first region on which the side wall is located, a second region obtained by etching the first region, and a step portion connecting the first region and the second region such that an angle formed between a side face of the step portion and an upper surface of the second region becomes an obtuse angle;
a third step of removing the side wall and then forming an insulating film over the side face of the control gate electrode on the side of the step portion, the first region, the step portion and the second region; and
a fourth step of forming a floating gate electrode on the side face of the control gate electrode on the side of the step portion and the second region including the step portion on the insulating film in a self-alignment manner.

12. The method for producing a non-volatile semiconductor storage device according to claim 11,
wherein in the second step, the step portion and the second region are formed by isotropic dry etching.

13. The method for producing a non-volatile semiconductor storage device according to claim 11,
wherein in the second step, the step portion and the second region are formed by wet etching.

14. The method for producing a non-volatile semiconductor storage device according to claim 11,
wherein in the second step, the step portion and the second region are formed by dry etching and wet etching.

15. The method for producing a non-volatile semiconductor storage device according to claim 11,
wherein in the second step, an angle formed between a side face of the step portion and an upper surface of the second region is about 100° or more.

16. The method for producing a non-volatile semiconductor storage device according to claim 11,
wherein in the second step, an angle formed between a side face of the step portion and an upper surface of the second region is about 110° or more and about 130° or less.

17. A method for producing a non-volatile semiconductor storage device comprising:
a first step of forming a gate insulating film and a gate electrode sequentially on a semiconductor substrate;
a second step of forming a side wall on a side face of the control gate electrode and then etching the semiconductor substrate using the formed side wall as a mask, thereby forming a first region on which the side wall is located, a second region obtained by etching the first region, and a step portion connecting the first region and the second region;
a third step of removing the side wall and then forming a first insulating film over the side face of the control gate electrode on the side of the step portion, the first region, the step portion and the second region by deposition;
a fourth step of forming a second insulating film at the interface between the first insulating film and the side face of the control gate electrode on the side of the step portion, the first region, the step portion and the second region by thermal oxidation; and
a fifth step of forming a floating gate electrode on the side face of the control gate electrode on the side of the step portion and the second region including the step portion on the first insulating film in a self-alignment manner.

18. The method for producing a non-volatile semiconductor storage device according to claim 17,
wherein in the third step, the first insulating film is an oxynitride film.

19. The method for producing a non-volatile semiconductor storage device according to claim 17,
wherein in the fourth step, the second insulating film is formed in an ambient containing nitrogen.

20. The method for producing a non-volatile semiconductor storage device according to claim 17, further comprising a step of performing an annealing treatment in a non-oxidative ambient with respect to the first insulating film and the second insulating film between the fourth step and the fifth step.

21. A method for producing a non-volatile semiconductor storage device comprising:
a first step of forming a gate insulating film and a gate electrode sequentially on a semiconductor substrate;
a second step of forming a side wall on a side face of the control gate electrode and then etching the semiconductor substrate using the formed side wall as a mask, thereby forming a first region on which the side wall is located, a second region obtained by etching the first region, and a step portion connecting the first region and the second region;
a third step of removing the side wall and then forming a first insulating film over the side face of the control gate electrode on the side of the step portion, the first region, the step portion and the second region by thermal oxidation;
a fourth step of forming a second insulating film on the first insulating film by deposition;
a fifth step of forming a third insulating film at an interface between the first insulating film and the side face of the control gate electrode on the side of the step portion, the first region, the step portion and the second region by thermal oxidation; and
a sixth step of forming a floating gate electrode on the side face of the control gate electrode on the side of the step portion and the second region including the step portion on the second insulating film in a self-alignment manner.

22. The method for producing a non-volatile semiconductor storage device according to claim 21,
wherein in the fourth step, the second insulating film is an oxynitride film.

23. The method for producing a non-volatile semiconductor storage device according to claim 21,
wherein in the fifth step, the third insulating film is formed in an ambient containing nitrogen.

24. The method for producing a non-volatile semiconductor storage device according to claim 21, further comprising a step of performing an annealing treatment in a non-oxidative ambient with respect to the first insulating film, the second insulating film and the third insulating film between the fifth step and the sixth step.
